# EUROPEAN PATENT APPLICATION

(11) **EP 2 421 052 A2**
(43) Date of publication of application: **22.02.2012**
(21) Application number: 10764684.6
(22) Date of filing: 16.04.2010
(51) Int. Cl.: H01L 31/042, H01L 21/66

(54) **SOLAR CELL AC ELECTROLUMINESCENCE IMAGE INSPECTING APPARATUS**

(30) Priority: 17.04.2009 KR 20090033746
(71) Applicant: MCScience Inc., Gyeonggi-do 443-470 (KR)
(72) Inventor: YOON, Chul Oh, Suwon-si Gyeonggi-do 443-746 (KR); KONG, Ung Girl, Suwon-si Gyeonggi-do 442-703 (KR); YI, Seong Ho, Hwaseong-si Gyeonggi-do 445-160 (KR)
(74) Representative: Collin, Jérôme
(86) International application number: PCT/KR2010/002377
(87) International publication number: WO 2010/120145

(57) **Abstract**

The present invention relates to a method and an apparatus for determining whether a solar cell is internally defective by inspecting electroluminescence images of the solar cell, and more specifically, relates to a solar cell AC electroluminescence images inspecting method apparatus applying AC power having predetermined periods to both ends of electrode of solar cell or module, detecting electroluminescence images generated from the solar cell using cameras, extracting the internal defects information of the solar cell, and determining the quality thereof.

The invention provides a solar cell AC electroluminescence image inspecting method and apparatus more safely, quickly, and precisely inspecting electroluminescence images by simultaneously extracting information on internal defects of a solar cell such as micro-cracks, contact resistance and internal resistance, hot spots and the like of the solar cell and the module and preventing heating damage to samples to be measured.

## Description

### BACKGROUND OF THE INVENTION

### 1. Technical Field

The present invention relates to a method and an apparatus for determining whether a solar cell is internally defective by inspecting electroluminescence images of the solar cell, and more specifically, relates to a solar cell AC electroluminescence image inspecting method and apparatus applying AC power supply having predetermined periods to both ends of electrodes of the solar cell or the module, detecting the electroluminescence images generated from the solar cell using cameras, extracting the internal defects information of the solar cell, and determining the quality thereof.

### 2. Description of the Related Art

In general, the solar cell is disposed outside and is used continuously for long periods under natural lights or concentrated solar-lights, such that the guarantee for the performance and lifetime of the solar cell is important for end user or manufacturers. The method inspecting the performance of the solar cell is performed by inspection regarding output characteristic, environment reliability and durability inspection by international standards wherein the inspection regarding output characteristic is performed as lot inspection to be use to quality control in the manufacturing process of the product, while various reliability inspection is a kind of a destructive inspection, thereby not performing the lot inspection.

When the defects of the solar cell are positioned inside thereof or defects that does not stand out due to a fine size are present, in using for a long time, progressive badness is developing, thereby weakening the performance of the solar cell and shortening lifespan. Therefore, it is necessary to inspect the solar cell when shipping product. Since such a progressive badness defect may be generated during the product manufacturing process, it is necessary to inspect in advance even in the manufacturing process in which the defects are expected to occur.

The internal defects of the solar cell may exist in various forms depending on characteristics of material and a structure of the element to be configured, and the manufacturing method. Crystalline semiconductor solar cell such as silicon (Si) and gallium arsenide (GaAs) uses a substrate formed with semiconductor material having structurally weak durability and therefore, the substrate is apt to crack or break by mechanical shocks or thermal expanding and contracting. When the micro-crack is present in the substrate, there is a high possibility for developing into the progressive badness.

Further, in the progress forming the electrode of the crystalline semiconductor solar cell, when metal paste does not form a sufficient electrical contact, partial contact resistance is increased, such that the performance thereof is lowered.

Further, in the progress forming the electrode of the crystalline semiconductor solar cell, when the metal material is penetrated inside the substrate, the metal material acts as shunt resistance, thereby lowering total output performance by unbalancing of current distribution or acts as hot spot defects, thereby leaking the current and generating high heat when partially applying reverse voltage in using the solar cell, such that the element may be damaged.

Even in the case of thin film solar cell using glass substrate or flexible substrate having excellent durability, the progressive defects such as electrical shorts, contact resistance, and shunt resistance may be formed due to inconsistence of patterns and foreign matter during etching in laminating and electrode pattern forming progress.

Various method such as ultrasonic thermal image, X-ray transmission, infrared thermal image, infrared spectroscopy and photo induce current measuring has been attempted as prior method inspecting the internal defects of the solar cell, but the method scanning stimulus point or detector takes much time for the inspection, has low resolution, requires high cost when using industrial infra-red or thermal image camera, and is not suitable for the lot inspection method of the solar cell in which high-speed measurements and large-area inspection are required.

The method, which is the method inspecting the internal defects of the solar cell by images, measuring electroluminescence images generated by applying DC power supply to both ends of the solar cell by the camera has recently been presented. When applying a predetermined power supply to the element having diode characteristics by the semiconductor junction structure, the electroluminescence phenomenon generated due to the electron-hole recombination according to the characteristics of the materials and the structure of the elements has generally been known wherein the invention is to detect internal defects from the electroluminescence images generated by applying the electroluminescence phenomenon to the solar cell

The electroluminescence spectrum generated from the silicon-based solar cell corresponds to the near infrared region of 950^{∼}1300 nm, and may be measured using the infrared image camera or the general CCD camera having excellent near-infrared sensitivity. The silicon-based solar cells have an indirect bandgap structure in which the electroluminescence efficiency is low and enough exposure time is required for detection of the image.

When applying the forward DC power supply to the solar cell, it has been known that the intensity of the electroluminescence generated from the surface of the solar cell is proportional to the current distribution of the corresponding portion(refer to document 1). If unbalanced current distribution is formed by structural defects, internal resistance and foreign matters within the solar cell, relative spatial distribution of the electroluminescence intensity may be detected by the image(refer to a document 2).

When applying reverse DC power supply to the solar cell, the internal defects related to the breakdown phenomenon at the diode structure are observed from the electroluminescence images, it has been known that which allows the current to leak and acts the hot spots (refer to a document 3).

PCT International patent publication No WO2007/129585Al of a document 4 presents the method measuring the electroluminescence images of the silicon-based solar cell by the camera wherein the method is characterized by detecting the electroluminescence images generated by forward applying DC having a magnitude of driving current when optical converting the solar cell, and determining the badness of the solar cell by obtaining two dimensional distribution of minority carrier diffusion length.

PCT International patent publication No WO2008/095467A1 of a document 5 presents the method inspecting the mechanical defects by detecting the electroluminescence images of intraband transition characteristics for p-n junction type solar cell of semiconductor material having indirect bandgap structure wherein the method is characterized by comparing the electroluminescence images according to the layer by selectively applying optical filter for the electroluminescence wavelength region. Even in this case, the method applying forward DC bias to drive electroluminescence is applied.

When applying forward DC power supply to the solar cell in the dark environment, non-linear current flows depending on the magnitude of the applied voltage applied by the characteristics of diode wherein the magnitude of the current may differ according to the samples to be measured when the difference in the energy conversion efficiency or mechanical defects are present according to the samples to be measured. Further, when applying the reverse high voltage power supply, the overcurrent flows by the breakdown characteristic of the diode, which brings thermal destruction of samples to be measured. Therefore, if the current flows into the samples of the solar cell, Joule heat is generated and the temperature is increased, so that the deviation of the measured temperature is generated according to the samples when inspecting the electroluminescence images, or the characteristic of the sample may be damaged when overheating.

When using the electroluminescence images inspection to a product inspection of the solar cell, the exposure time of camera for detection should be provided enough, while the exposure time may need to be limited to increase the inspecting speed. The defects information provided by the forward electroluminescence images and the reverse electroluminescence images is different from each other, and therefore, when applying the power supply in DC way to get the whole defects information, the forward and the reverse images photographing requires at least 2 times, thereby losing half the inspection speed.

The document information of the prior art.
[Document 1] Takashi Fuyuki et. al., Appl. Phys. Lett., 86, 262108 (2005)
[Document 2] T. Trupke et. al., Proceeding of 22nd European Photovoltaic Solar Energy Conference, Milano, Italy, p22-31 (2007)
*[Document 3] Otwin Breitenstei et. al., Prog. Photovolt. Res. Appl., 16, 325 (2008)
[Document 4] WO 2007/129585 Al, 2007.11.15
[Document 5] WO 2008/095467 Al, 2008.09.14

### SUMMARY OF THE INVENTION

To realize the electroluminescence images inspection for determining whether the solar cell is internally defective, the invention provides a solar cell AC electroluminescence image inspecting method and an apparatus thereof capable of more safely, quickly, and precisely inspecting electroluminescence images by simultaneously extracting information on various internal defects of a solar cell such as micro-cracks, contact resistance and internal resistance, hot spots and the like of the solar cell and the module and preventing heating damage to samples to be measured.

To realize the electroluminescence images inspection for determining whether the solar cell is internally defective, the invention is characterized by preventing the heating damage of the solar cell to be measured and by simultaneously measuring the internal defects detected from each of the forward and reverse electroluminescence images inspection by applying AC power having predetermined periods to both ends of electrode of the solar cell or the module and driving the AC electroluminescence by the forward and the reverse amplitude modulation to be repeated during a short time.

### BRIEF DESCRIPTION OF THE DRAWINGS

FIG. 1 is a configuration view of a solar cell AC electroluminescence images inspecting apparatus: a solar cell to be measured 1, a power supply means 2, a image detecting means 3, an image processing means 4, an image data obtaining unit 41, a defect detecting unit 42, a defect information output unit 43.
FIG. 2 is an output waveform of AC form provided with the power supply means of the solar cell AC electroluminescence images inspecting apparatus: (a) a sinusoidal wave, (b) a square wave, (c) a saw tooth wave, and (d) a ramping pulse wave.
FIG. 3 is electroluminescence images generated when forward applying DC voltage to polycrystalline silicon solar cells: a defect 51 that is estimated as mechanical cracks, and a defect 52 that is estimated as loose contact of an electrode.
FIG. 4 is electroluminescence images generated when reverse applying DC voltage to the same polycrystalline silicon solar cells as FIG. 3: a defect 53 that is estimated as hot spots.
FIG. 5 is electroluminescence images generated when applying AC voltage of pulse form to the same polycrystalline silicon solar cells as FIG. 2 and 3: the defect 51 that is estimated as mechanical cracks, the defect 52 that is estimated as loose contact of an electrode, and the defect 53 that is estimated as hot spots.
FIG. 6 is electroluminescence images generated when applying AC voltage of pulse form to the polycrystalline silicon solar cells: the defect 54 that is estimated as micro-cracks and the defect 53 that is estimated as hot spots.
FIG. 7 is images in capturing the scene, in which overcurrent caused when reversely applying DC voltage to the polycrystalline silicon solar cells is generated and therefore, the cell is damaged, by the camera.
FIG. 8 is electroluminescence images generated when applying AC voltage of pulse form to single crystal silicon solar module: the defect 51 that is estimated as mechanical cracks, the defect 52 that is estimated as loose contact of an electrode, and the defect 53 that is estimated as micro-cracks.
FIG. 9 is method detecting defects of solar cell using solar cell AC electroluminescence images inspecting apparatus including CCD camera, AC power and solar cell.
FIG. 10 is a graph showing a normalized spectral responsivity 31 of a general silicon CCD camera and a normalized electroluminescence spectrum 32 of the single crystal silicon solar cells.

### DESCRIPTION OF THE PREFERRED EMBODIMENTS

Description of the present invention will be described in detail with reference to the attached drawings.

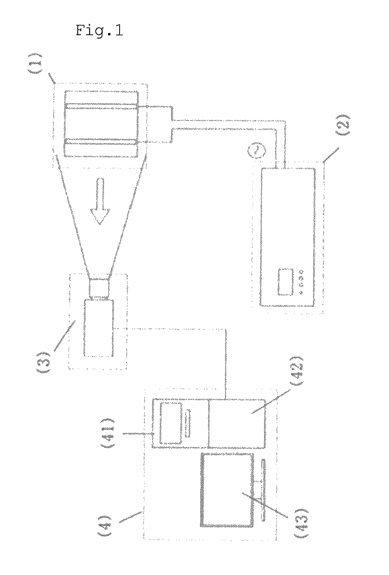

FIG. 1 is a configuration view of a solar cell AC electroluminescence images inspecting apparatus according to an exemplary embodiment of the invention, and includes a power supply unit 2, an images detecting unit 3, and an images processing unit 4.

First, the power supply unit 2 is electrically connected to both ends of the electrode for the solar cells 1 to be measured to apply AC voltage or current having a predetermined period, and may apply AC voltage or current modulated with forward and reverse amplitude to be repeated during a short time.

If the AC voltage or current modulated with the forward and the reverse amplitude to be alternatively repeated during a short time is applied to the solar cell 1, the solar cell or module 1 light-emits the specified images according to change in AC electric field.

The images detecting unit 3 detects the electroluminescence images generated from the solar cell to be measured using the camera, and transmits the detected electroluminescence images to the images processing unit 4.

The images detecting unit 3 is positioned in the direction of light-receiving surface of the solar cell 1 to be measured, includes the camera photographing light images radiated from the light-receiving surface, and is configured by at least one camera.

The images detecting unit 3 provides the photographed electroluminescence images to the images processing unit 4 by analog or digital signal form.

The images processing unit 4 analyzes the transmitted electroluminescence images to extract internal defects information of the solar cell, and includes an images data obtaining means 41, a defects detecting means 42 and a defects information output means 43.

The images data obtaining means 41 converts the analog or digital images signal provided from the images detecting unit 3 into the digital images data. The defects detecting means 42 compares the converted images data with reference images data to automatically extract the defects information, analyzes the defects information, and determines the quality of the solar cell 1.

For example, when the defects information extracted from the solar cell 1 to be inspected includes the defects information only to be included in the predetermined range, the quality evaluation becomes "good". When exceeding the predetermined range, the quality evaluation becomes "badness".

The defects information output means 43 may output the extracted defects information and the quality determination result as the analog or digital signal.

The solar cell 1 to be measured is configured in the solar cell or module form, and main material of the solar cell or module may be made of single crystal, polycrystalline, microcrystal, nanocrystal or amorphous silicone-based semiconductor representing electroluminescence characteristic at invisible light or near-infrared region , III-V group compound semiconductor such as gallium arsenide(GaAs), cadmium-based compound semiconductor such as Cd-Te, Cu-In-based compound semiconductor such as Cu-In-Ga-S, oxide semiconductor such as Ti02, dye composites or organic matter semiconductor.

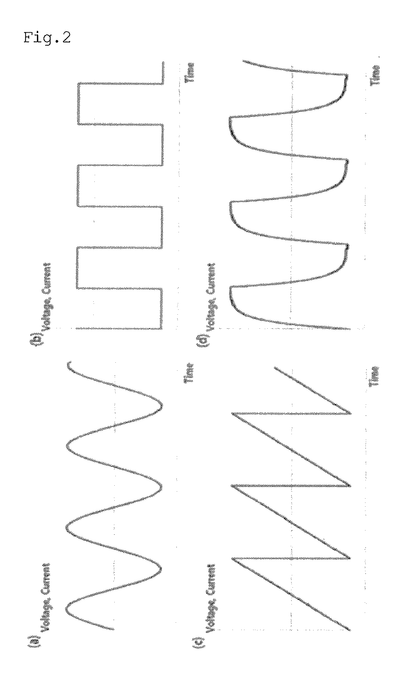

FIG. 2 shows a waveform of various AC voltage or current applied to the solar cell using the solar cell AC electroluminescence images inspecting apparatus according to the embodiment of the invention.

As shown in FIG. 2, the waveform of various AC voltage or current applied to the solar cell using the solar cell AC electroluminescence images inspecting apparatus according to the embodiment of the invention may appear in periodic function form such as a sinusoidal wave, a square wave, a saw tooth wave, and a ramping pulse wave.

The AC output waveform may selectively set the AC output period by controlling modulation frequency, and if the maximum value of the AC output is set forward and the minimum value is set reversely, the forward and reverse output may be applied alternatively and repeatedly in a short time.

The AC voltage or current is applied to the solar cell using above method, and therefore, there is an effect that the forward and reverse AC voltage or current is alternatively applied to the solar cell.

Accordingly, when the forward and reverse AC voltage or current is alternatively applied, the images detecting unit 3 may photograph so that forward electroluminescence images and reverse electroluminescence images are overlapped to each other.

The period of AC output applied from the power supply unit 2 should be much smaller than that of photographing exposure time of the images detecting unit 3.

Since the power supply unit 2 may switch and apply high current forward and high voltage reversely with high speed, which is effective to protect electrical breakdown for the solar cell to be measured or module having diode characteristic.

When using the square wave as AC output of the power supply unit 2, the power supply unit 2 may adjust detection intensity of forward electroluminescence images and reverse electroluminescence images by controlling width of the square pulse.

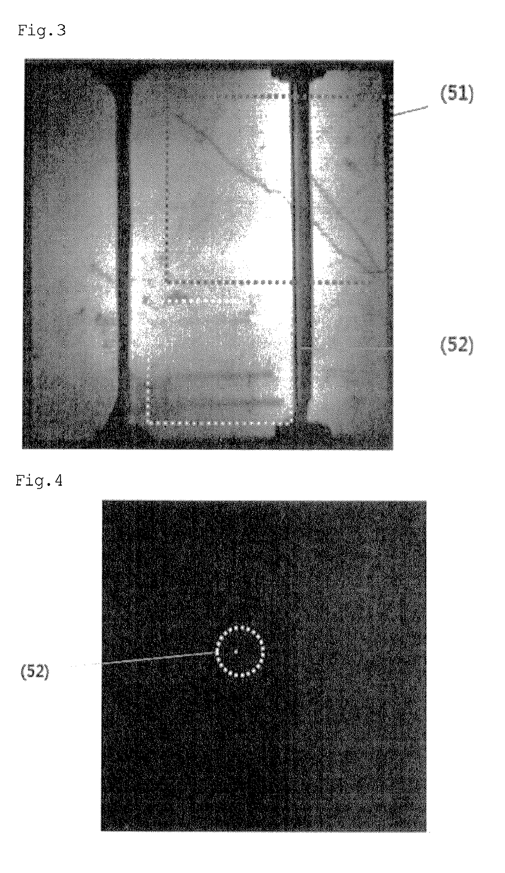

FIG. 3 is electroluminescence images photographed when forward applying the DC voltage to the polycrystalline silicon solar cells, and FIG. 4 is electroluminescence images photographed when reversely applying DC voltage to the same polycrystalline silicon solar cells as FIG. 3.

As shown in FIG. 3 and 4, when forward applying the DC voltage to the solar cells, the defect 51 that is estimated as mechanical cracks and the defect 52 that is estimated as loose contact of an electrode are detected in the inside of the solar cell, and the defect 52 that is estimated as hot spots, when reversely applying DC voltage to the solar cells, are observed, respectively.

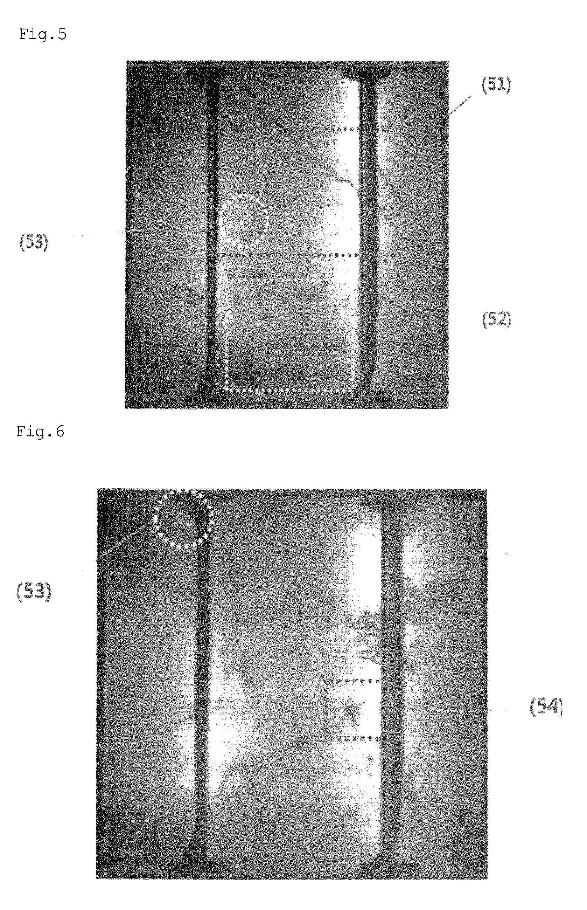

FIG. 5 is electroluminescence images generated when applying AC voltage of pulse form to the same polycrystalline silicon solar cells as FIG. 2 and 3 using solar cell AC electroluminescence images inspecting apparatus according to first embodiment of the invention.

As shown in FIG. 5, the defect 51 that is estimated as mechanical cracks and the defect 52 that is estimated as loose contact of an electrode and the defect 53 that is estimated as hot spots in the inside of the solar cell are simultaneously observed from the electroluminescence images photographed by the solar cell AC electroluminescence images inspecting apparatus according to the first embodiment of the invention in one image.

That is, when detecting the defects of the solar cell or the module using the solar cell AC electroluminescence images inspecting apparatus according to the embodiment of the invention, the defects of forward and reverse AC electroluminescence may be detected simultaneously in one image.

At this time, the maximum value of the applied AC voltage becomes forward voltage and the minimum value becomes reverse voltage.

FIG. 6 is the electroluminescence images photographed by the solar cell AC electroluminescence images inspecting apparatus according to the second embodiment of the invention.

The images photographed by the solar cell AC electroluminescence images inspecting apparatus according to the second embodiment of the invention becomes the images generated when applying the AC voltage of the pulse form to the polycrystalline silicon solar cells in which the defect 54 that is estimated as micro-cracks and the defect 53 that is estimated as hot spots in the inside of the solar cell are observed simultaneously in one image.

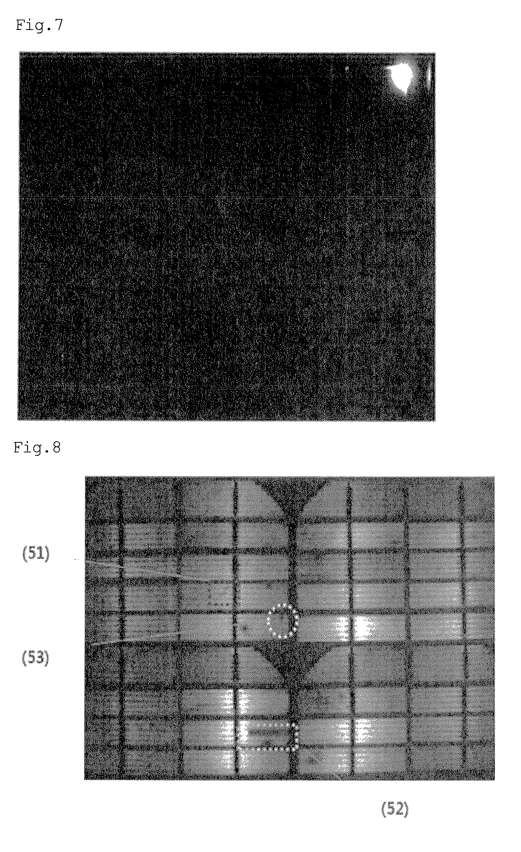

FIG. 7 is images in capturing the scene, in which overcurrent that is estimated as breakdown of the solar cell or short at the cell corner when reversely applying direct voltage to the polycrystalline silicon solar cells is generated and therefore, the cell is damaged, by the camera.

FIG. 8 shows electroluminescence images generated when applying AC voltage of pulse form to single crystal silicon solar cells module using the solar cell AC electroluminescence images inspecting apparatus according to the third embodiment of the invention, and in the same drawing, the defect 51 that is estimated as mechanical cracks, the defect 52 that is estimated as loose contact of an electrode, and the defect 54 that is estimated as micro-cracks in the inside of the cell are observed simultaneously in one images.

The solar cell AC electroluminescence images inspecting apparatus according to the invention may simultaneously extract various internal defects of solar cell such as the mechanical cracks, contact cracks, and hot spots present in the solar cell and prevent specimen to be measured from heating and damaging by applying the AC voltage or AC current and using the method inspecting the electroluminescence images of the solar cell or the module, thereby to implement the solar cell electroluminescence images inspecting apparatus capable of more safely, fast and precisely inspecting.

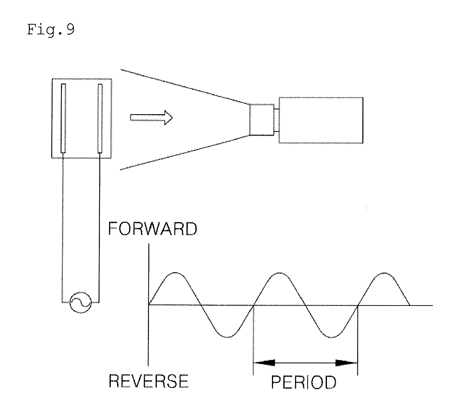

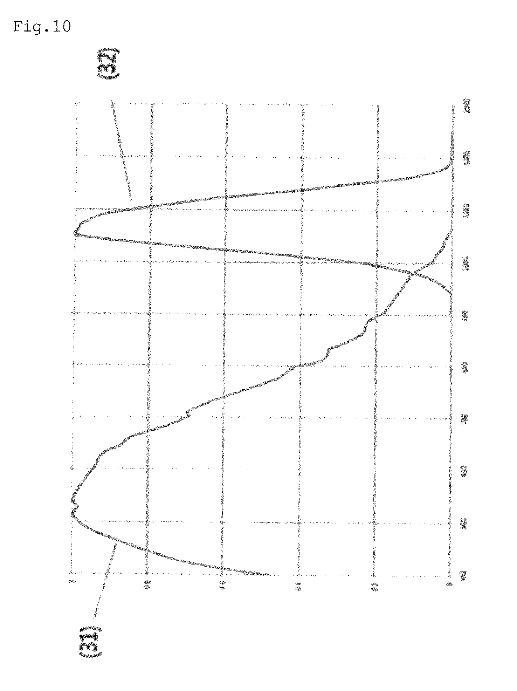

FIG. 9 explains the method detecting the defects of the solar cell using the camera including the CCD element of the solar cell AC electroluminescence images inspecting apparatus according to the fourth embodiment of the invention, and FIG. 10 shows the emission spectrum of solar cell detected by the camera.

The solar cell AC electroluminescence images inspecting apparatus according to the fourth embodiment of the invention controls the modulation frequency in the range of 1 Hz ^{∼} 10 KHz and includes an AC power supply unit providing square waveform output having the voltage range of -20 V ^{∼} +20 V and the current range of -10 V ^{∼} +10 A.

Further, the solar cell AC electroluminescence images inspecting apparatus according to the fourth embodiment of the invention is configured by Leutron P142AM silicon CCD camera having the resolution of 1360x1024, Camera Link frame grabber and control PC supporting 64MB, 85MHz, PCI-X, and self-developed images processing software.

As shown in FIG 10, the emission spectrum of solar cell detected by the camera of the solar cell AC electroluminescence images inspecting apparatus according to the fourth embodiment of the invention is an experiment data measuring electroluminescence spectrum of the solar cell with the exposure time of 1000 msec when applying AC power supply having square pulse forms of forward current control-reverse voltage control type repeatedly outputting forward current of 6A and reverse voltage of -8.5 V to the polycrystalline solar cell having a size of 156 mm x 156 mm.

At this time, the frequency of the AC power supply provided to the solar cell is 100 Hz, the duty rate of the forward ampiltude is 80%, and a plurality of internal defects such as the defect 51 that is estimated as internal mechanical cracks, the defect 52 that is estimated as loose contact of an electrode, the defect 53 that is estimated as hot spots, and the defect 54 that is estimated as mirco-cracks in the electroluminescence images detected by the camera may be detected simultaneously in one image.

AC electroluminescence images inspecting method according to the invention may simultaneously extract internally defective information of various solar cell such as the mechanical cracks, contact resistance, and hot spots provided by each of the forward and the reverse electroluminescence images, and prevent the heating damage of the samples to be measured, by only once photographing electroluminescence images of the solar cell and module , thereby implementing the solar cell electroluminescence images inspecting method and apparatus capable of more safely, fast and precisely inspecting.

The solar cell electroluminescence images inspecting apparatus of the invention may be used as an equipment for quality control of final products and in-line inspections according to the process when manufacturing the solar cell and the module, and may be used as the equipment for the performance test and analysis evaluating the characteristics of the solar cell when developing the material and elements of the solar cell.

### ACKNOWLEDGEMENT

This work was supported by the New & Renewable Energy of the Korea Institute of Energy Technology Evaluation and Planning (KETEP) grant funded by the Korea government Ministry of Knowledge Economy. (No. 2009301001002A)

## Claims

1. A solar cell AC electroluminescence image inspecting method, comprising:
electrically connecting a power supply unit to both ends of electrode of solar cell or module to apply AC power having predetermined periods and waveforms to the both ends thereof by the power supply unit;
detecting electroluminescence images generated from the solar cell or the module using cameras; and
extracting internal defects information of the solar cell from the electroluminescence images detected from the solar cell or the module when applying the AC power having the predetermined periods and waveforms by the power supply unit.

2. The solar cell AC electroluminescence image inspecting method, according to claim 1, wherein the solar cell or the module is made of any one of single crystal, polycrystalline, microcrystal, nanocrystal or amorphous silicone-based semiconductor representing electroluminescence characteristic at invisible light or near-infrared ray region, III-V group compound semiconductor such as gallium arsenide(GaAs), cadmium-based compound semiconductor such as Cd-Te, Cu-In-based compound semiconductor such as Cu-In-Ga-S, oxide semiconductor such as Ti02, dye composites or organic material semiconductor.

3. The solar cell AC electroluminescence image inspecting method, according to claim 1, wherein output waveforms of the AC power applied from the power supply unit are periodic functions such as a sinusoidal wave, a square wave, a saw tooth wave, or a ramping pulse wave.

4. The solar cell AC electroluminescence image inspecting method, according to claim 1, wherein the power supply unit alternatively outputs forward voltage or current and reverse voltage or current.

5. The solar cell AC electroluminescence image inspecting method, according to claim 1, wherein the AC output waveforms applied from the power supply unit are configured by forward amplitude and reverse amplitude and are square periodic functions capable of adjusting duty rate of forward pulse width and reverse pulse width.

6. The solar cell AC electroluminescence image inspecting method, according to claim 1, wherein the period of AC power applied from the power supply unit is 1000 msec or less.

7. The solar cell AC electroluminescence image inspecting method, according to claim 1, wherein in the detecting of the electroluminescence images generated from the solar cell or the module by using the camera, the camera used for detecting the electroluminescence images uses silicon-based one or two dimensional arranged CCD elements in which range of wavelength includes invisible light or near-infrared region.

8. A solar cell AC electroluminescence image inspecting apparatus, comprising
a power supply unit electrically connected to both ends of electrode of solar cell or module and applying AC power having predetermined periods and waveforms to the both ends thereof ;
an image detecting unit detecting the electroluminescence images generated from the solar cell or the module applied the AC power, by using the camera; and
an image processing unit automatically extracting the internal defects information of the solar cell or the module from the detected electroluminescence images.

9. The solar cell AC electroluminescence image inspecting apparatus according to claim 8, wherein the output waveforms of the AC power applied from the power supply unit are periodic functions such as a sinusoidal wave, a square wave, a saw tooth wave, or a ramping pulse wave.

10. The solar cell AC electroluminescence images inspecting apparatus according to claim 8, wherein the AC power applied from the power supply unit alternatively outputs forward voltage or current and reverse voltage or current.

11. The solar cell AC electroluminescence image inspecting apparatus according to claim 8, wherein the AC output waveforms applied from the power supply unit are configured by forward pulse and reverse pulse and are square periodic functions capable of adjusting duty rate of forward pulse width and reverse pulse width.

12. The solar cell AC electroluminescence images inspecting apparatus according to claim 8, wherein the period of AC power applied from the power supply unit is 1000 msec or less.

13. The solar cell AC electroluminescence images inspecting apparatus according to claim 8, wherein camera of the image detecting unit uses silicon-based one or two dimensional arranged CCD elements in which range of wavelength includes the invisible light or the near-infrared region.

14. The solar cell AC electroluminescence image inspecting apparatus according to claim 8, wherein the image processing unit includes,
an image data conversion means converting the electroluminescence image detected from the images detecting unit into digital image data;
a defects detecting means automatically extracting the defects information by comparing the converted image data with reference images data, analyzing the defects information, and determining the quality of the solar cell or the module; and
a defects information output means outputting the extracted defects information and the quality determining result as with analog or digital signal.
